# EUROPÄISCHE PATENTSCHRIFT

(11) **EP 1 215 721 B1**
(45) Veröffentlichungstag und Bekanntmachung des Hinweises auf die Patenterteilung: **23.01.2008**
(21) Anmeldenummer: 01124788.9
(22) Anmeldetag: 17.10.2001
(51) Int. Cl.: H01L 21/68

(54) **Verfahren zur mehrschrittigen Bearbeitung eines dünnen und unter den Bearbeitungsschritten bruchgefährdeten Halbleiter-Waferprodukts**
Process for multistep processing of a thin and brittle Wafer
Procédé pour le traitement en plusieurs étapes d'une plaquette semiconductrice mince et cassante

(30) Priorität: 13.12.2000 DE 10062015; 21.08.2001 DE 10140826
(43) Veröffentlichungstag der Anmeldung: 19.06.2002
(73) Patentinhaber: Infineon Technologies AG, 81669 München (DE)
(72) Erfinder: Kröner, Friedrich, 9500 Villach (AT); Schmidt, Thomas, 9500 Villach (AT)
(74) Vertreter: Kindermann, Peter

(56) Entgegenhaltungen:
- US-A- 4 339 870
- US-A- 5 563 084
- US-A- 5 827 751

## Beschreibung

Die Erfindung betrifft ein Verfahren zur mehrschrittigen Bearbeitung eines dünnen und unter den Bearbeitungsschritten bruchgefährdeten Halbleiter-Waferprodukts.

Waferprodukte erhalten herkömmlich auf der Rückseite des elektrisch aktiven Gebietes Strukturen, die zu ihrer Erzeugung mit einer Hochtemperaturbehandlung verbunden sind. Um dabei die Handhabbarkeit des Waferprodukts zu ermöglichen, muss an dessen aktiver Vorderseite mittels einer Bondingschicht ein vorderseitiges Trägersubstrat angebracht werden. Hochtemperaturbehandlung bedeutet in diesem Zusammenhang, dass die Temperaturen bei dem betreffenden Arbeitsschritt bei 450 °C oder darüber liegen. Die Hochtemperaturschritte sind dabei meist sogar mit Temperaturen verbunden, die den Schmelzpunkt von Aluminium (etwa 650 °C) wesentlich überschreiten. Daher können Metallisierungs- und Passivierungslagen erst danach aufgebracht werden. Dies erfordert, dass wechselweise sowohl auf der Vorderseite als auch auf der Rückseite des Waferprodukts Hochtemperaturträger angebracht und wieder entfernt werden. Bei einer solchen Anbringung von Trägern bzw. der Hochtemperaturbehandlung ist das Waferprodukt in höchstem Maße bruchgefährdet. Dadurch entsteht bei der Produktion ein unerwünscht hoher Ausschussanteil.

Endprodukte, die auf dem besagten Waferprodukt (meist ein dünner Siliziumwafer mit einer Dicke von weniger als 100 Mikrometern) basieren, sind beispielsweise dünne Feldstopp-IGBT's oder -Dioden, die schon vor der ersten Metallisierung eine Rückseiten-Hochtemperaturbearbeitung benötigen. Danach erst können sie mit einer Metallisierung und Passivierung (strukturiert) auf der Vorderseite versehen werden. Meist erhalten diese Endprodukte noch eine Metallisierung auf der Rückseite, eine Diffusionsbehandlung im Diffusionsofen, eine beidseitige Kontaktierung für elektrische Tests usw..

Um den Ausschuss durch Bruch des Waferprodukts zumindest einigermaßen in Grenzen zu halten, sind bisher komplexe und aufwendige Maßnahmen bei der Handhabung und Behandlung bzw. bei den oben genannten Produktionsschritten erforderlich. Hierzu gehören z.B. ein Folienbond auf dem Trägerwafer zum Dünnen selbst, der Einsatz einer speziellen Reinigungsanlage für dünne Wafer, die Konstruktion geeigneter Transporthorden und Transportvorrichtungen, speziell ausgebildete Ionenimplanter, Klemm- und Torsionsringe für die Rückseiten-Metallisierung und Tests, Spezialanfertigung von Greifern und Umhordeautomaten, Beschaffung von Probern, die von beiden Seiten mit Nadeln hantieren können, usw..

Trotz solcher Massnahmen ist der Ausschuss durch Bruch des Waferprodukts bereits bei über 100 Mikrometern dünnen Wafern sehr hoch. Bisherige Anstrengungen erfordern, um die Ausschussrate in einigermaßen akzeptablen Grenzen zu halten, ein äußerst unbefriedigendes, häufiges Montieren und Demontieren eines Trägersubstrates wechselweise sowohl auf die Vorderseite als auch auf die Rückseite, welches mit extrem hohem Aufwand und einer dadurch bedingten zusätzlichen Erhöhung der Ausschussrate verbunden ist.

Aus der Druckschrift US-A-4339870 ist ein Verfahren zur mehrschrittigen Bearbeitung eines GaAs-Wafers bekannt, an dessen Oberfläche eine GaAlAs-Pufferschicht und darauf eine aktive n-dotierte GaAs- sowie n⁺-dotierte GaAs-Schicht epitaktisch abgeschieden werden. Auf der Wafer-Vorderseite wird anschließend ein Diamant-Trägersubstrat aufgebracht und das GaAs-Substrat sowie die GaAlAs-Pufferschicht entfernt, wodurch sich voneinander beabstandete aktive Gebiete ergeben.

Der Erfindung liegt daher die Aufgabe zugrunde, bei verringertem Arbeits- und apparativem Aufwand und vereinfachter Handhabung des Waferprodukts den Ausschuss bei der Produktion der eingangs genannten Produkte zu verringern bis gänzlich zu vermeiden.

Diese Aufgabe wird durch die im Patentanspruch 1 angegebenen Merkmale gelöst.

Erfindungsgemäß wird somit die Rückseite des Waferprodukts einer Hochtemperaturbehandlung unterworfen, während an dessen aktiver Vorderseite ein vorderseitiges Trägersubstrat montiert ist. Daraufhin wird auf die Rückseite und/oder ein Rückseiten-Substrat aus leitfähigem Material eine Metallbasis-Bondingdeckschicht aufgetragen. Das Rückseiten-Substrat wird anschließend durch Ausbildung des dazwischenliegenden Metallbasis-Bondingmaterials durch Wärmebehandlung mit der Rückseite des Waferprodukts verbunden. Dabei entsteht eine leitfähige Metallbasis-Bondingschicht. Dann ist das Waferprodukt durch das fest montierte Rückseiten-Substrat handhabbar, ohne dass die Gefahr eines Bruchs besteht. Daher kann das Trägersubstrat von der Vorderseite entfernt und die Vorderseite (strukturiert) metallisiert/passiviert werden.

Dabei wird das Metallbasis-Bondingmaterial hinsichtlich seiner physikalisch-chemischen Eigenschaften unter Berücksichtigung des Waferprodukt-Materials und der bei der Metallisierung/ Passivierung und insbesondere auch bei zusätzlichen, darauffolgenden Bearbeitungsschritten herrschenden Temperaturen und verwendeten Materialien derart ausgewählt, dass die beteiligten, in benachbarten Schichten angeordneten Materialien, insbesondere das Waferprodukt-Material und das Metallbasis-Bondingmaterial, praktisch unmischbar sind. Dies bedeutet, dass sich unter den genannten Bearbeitungsschritten, insbesondere der Metallisierung/Passivierung, keine oder lediglich eine unwesentliche chemisch-physikalische Verbindung zwischen den Materialien ausbildet.

Durch die vorgenannte Temperaturbeständigkeit der beteiligten Schichten ist die Verbindung mittels des Metallbasis-Bondingmaterials praktisch endgültig, so dass sämtliche folgende Bearbeitungsschritte unter Beibehaltung des montierten Rückseiten-Substrats ausgeführt werden können. Dabei wurde in Verbindung mit der Erfindung erkannt, dass hierzu einerseits die chemische Inkompatibilität der genannten Schichten bei den genannten Bearbeitungsschritten und andererseits die Leitfähigkeit der Rückseite erforderlich sind. Zu den genannten Bearbeitungsschritten gehört nämlich stets auch zumindest ein elektrischer Test, bei dem die Rückseite kontaktiert sein muss. Dieses Problem wird durch die Erfindung gelöst, wobei die Handhabbarkeit des Waferprodukts samt aller vorhandenen Schichten stets erhalten bleibt.

Die Unmischbarkeit kann schon dadurch gewährleistet sein, dass die ausgebildete Metallbasis-Bondingschicht unter den Bearbeitungsschritten von allen Eutektika der benachbarten Schichten im Phasendiagramm weit genug entfernt bleibt, d. h. dass die Temperaturen insbesondere deutlich unterhalb allen eutektischen Temperaturen liegen. Hierauf wird später noch näher eingegangen.

Somit wird die Verbindungsbildung der Schichten dadurch verhindert, dass eine gegenseitige Migration verringert beziehungsweise unterdrückt wird. Die wesentlichen elektrischen Eigenschaften des Waferprodukts bleiben dabei aber, insbesondere in den Grenzschichten, unbeeinflusst. Das Rückseiten-Substrat kann auch problemlos wieder von dem Waferprodukt abgelöst werden.

Bevorzugte Ausgestaltungen der vorliegenden Erfindung sind Gegenstand der Unteransprüche.

Die Forderung nach Unmischbarkeit wird unter gleichzeitiger Verwendung eines chemisch relativ inerten Materials dadurch erfüllt, dass als Metallbasis-Bondingmaterial Silberpaste, insbesondere Dickschicht-Silberpaste oder eine Leitpaste aus Silberlegierungen, anderen Edelmetallen oder Edelmetalllegierungen verwendet wird. Dies hat auch den Vorteil, dass bei den nachfolgenden Bearbeitungsschritten das Metallbasis-Bondingmaterial - insbesondere bei Verwendung von Flußsäurelösungen - möglichst wenig chemisch angegriffen wird.

Eine vorteilhafte Ausbildungstemperatur, die einerseits eine vollständige Ausbildung gewährleistet und andererseits den jeweiligen eutektischen Temperaturen fernbleibt, liegt zwischen 500 und 700 °C.

Wenn eine Al-Metallisierung vorgesehen ist, die vor der Ausbildung bzw. Formierung aufgebracht wird, wird vorgeschlagen, dass die Formierungstemperatur der Metallbasis-Bondingschicht kleiner oder gleich 500 °C ist. Bei dieser Temperatur ist eine gute Formierung noch immer gewährleistet, wobei aber zusätzlich die Vorteile der Al-Schicht genutzt werden können, ohne dass diese zerstört wird.

Als Metallbasis-Bondingmaterial kann auch Gold verwendet werden. Hierbei sind zwischen dem Goldmaterial und dem Waferprodukt-Material Barriereschichten vorgesehen, um eine gegenseitige Migration zu verhindern.

Dabei kann die Verbindung mittels Gold-Druck-Bonding realisiert werden.

Das Waferprodukt kann beispielsweise monokristallines Silizium mit einer Schichtdicke von weniger als 100 Mikrometern sein. Auch bei einer solchen, relativ geringen Schichtdicke gewährleistet die Erfindung eine sichere Handhabbarkeit. Dadurch können erstmals solche dünnen Waferprodukte zuverlässig und bei geringer Ausschussrate weiterbearbeitet werden.

Um Spannungen durch unterschiedliche Wärmeausdehnung der beteiligten Materialien vorzubeugen, weist bevorzugt das Material des Rückseiten-Substrats einen thermischen Ausdehnungskoeffizienten auf, der dem des Waferprodukt-Materials entspricht. Dadurch werden die erfindungsgemäßen Maßnahmen ideal ergänzt, da erstmalig eine gemeinsame Bearbeitung des Waferprodukts zusammen mit dem Rückseiten-Substrat bei höheren Temperaturen möglich ist und dadurch die vorgenannte Materialauswahl wirksam zum Tragen kommt. Beispielsweise kann das Rückseiten-Substrat aus höchstdotiertem, monokristallinem Silizium bestehen. Dadurch wird einerseits der schädliche Serienwiderstand minimiert und andererseits, insbesondere bei Verwendung eines Silizium-Waferprodukts, die Kompatibilität der Wärmeausdehnungen gewährleistet.

Vorzugsweise besteht das Rückseiten-Substrat aus nicht monokristallinem Halbleitermaterial, wodurch sich die Herstellungskosten wesentlich verringern lassen. Insbesondere bei Verwendung eines multikristallinen Trägerwafers als Rückseiten-Substrat können im Gegensatz zu einem monokristallinen Trägerwafer ca. 9/10 der Materialkosten eingespart werden.

Zusätzlich können auf der Rückseite des Waferprodukts vor dessen leitfähiger Verbindung mit dem Rückseiten-Substrat Hochtemperatur-Diffusionen durchgeführt oder metallische Verdrahtungsstrukturen ausgebildet werden.

Die Erfindung wird nachstehend anhand von Ausführungsbeispielen unter Bezugnahme auf die Zeichnung näher beschrieben. Es zeigen:
Figur 1a bis 1c eine Bearbeitungssequenz eines Waferprodukts mit einem Rückseiten-Substrat, welches am Produkt verbleibt;
Figur 2a bis 2c eine Bearbeitungssequenz mit einer Metallfolie, wobei das Rückseiten-Substrat wiederverwendbar ist;
Figur 3 einen vergrößerten Ausschnitt der Silberpaste; und
Figur 4 einen Ausschnitt einer mechanischen Pufferzone einer Metallfolie,
jeweils anhand eines Querschnitts durch das betreffende Schichtpaket.

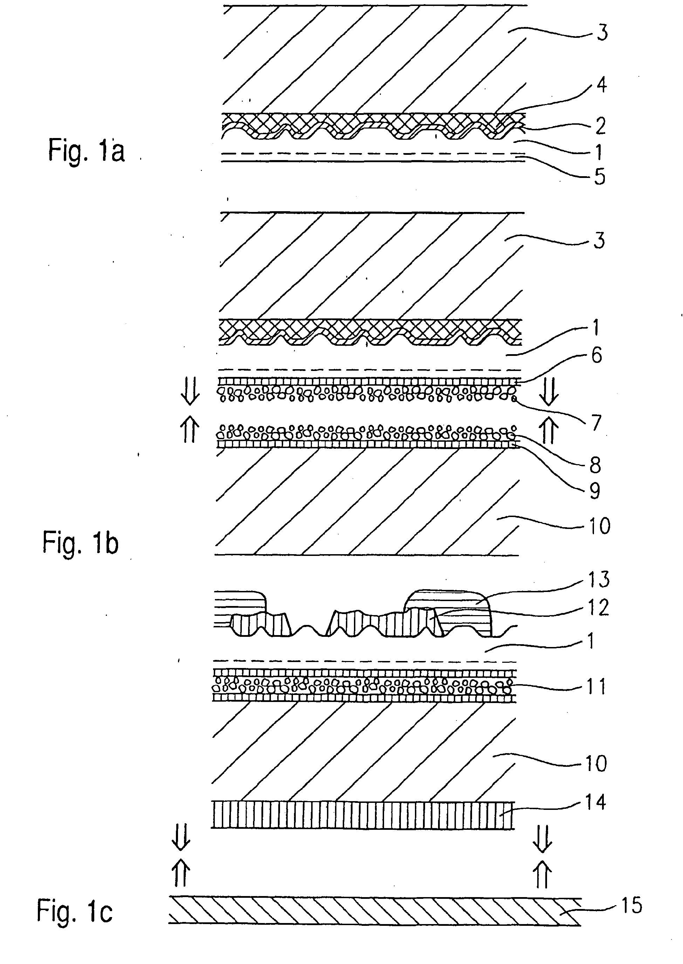

Die Figuren 1a bis 1c zeigen eine erfindungsgemäße Bearbeitungssequenz eines Waferprodukts 1. Auf die Vorderseite des Waferprodukts 1 sind Höhenstrukturen aufgebracht, und die Vorderseite des Waferprodukts 1 ist mit einer flußsäurebeständigen Schutzschicht 2 versehen. Daran schließt sich eine Flüssigglas-Bondingschicht 4 an, mittels der ein Vorderseiten-Substrat 3 an dem Waferprodukt 1 angebracht ist. Die bei höheren Temperaturen durchgeführten Diffusionen zur Dotierung sind bereits abgeschlossen. Dies ist durch eine mittels durchbrochener Linie angedeutete Diffusions-Grenzzone 5 dargestellt.

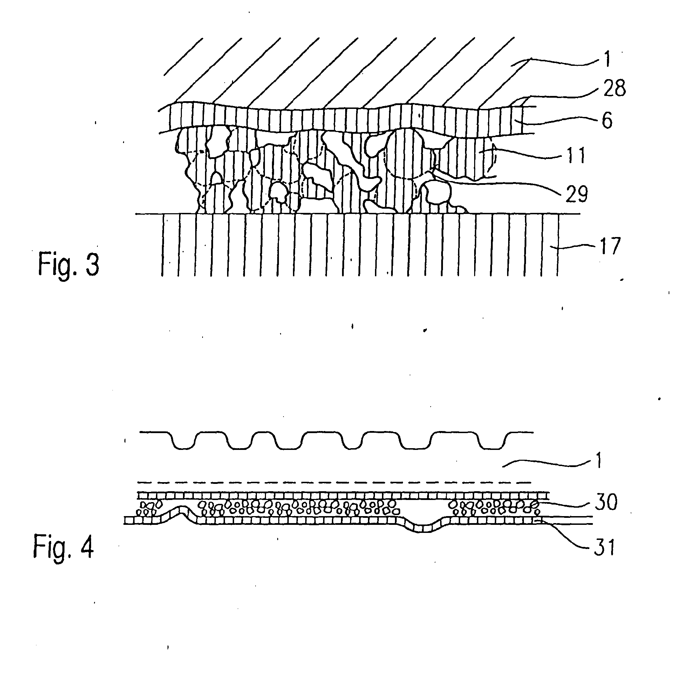

Hiervon ausgehend wird zunächst eine Rückseiten-Metallisierung 6 auf die Rückseite des Waferprodukts 1 aufgebracht. Diese Schicht besteht beispielsweise aus metallischem Silber. Die Rückseiten-Metallisierung 6 wird bereits vor der Metallisierung/Passivierung der Vorderseite aufgebracht. Daraufhin wird, beispielsweise mittels eines Siebdruckverfahrens, eine planarisierte Schicht 7 von Silberpartikeln 29 (vgl. Fig. 3) aufgebracht. Eine korrespondierende Metallbasis-Bondingdeckschicht 8 wird daraufhin auf das Rückseiten-Substrat 10 aufgebracht; vorher kann auf das Rückseiten-Substrat 10 eine Metallisierung 9 als Barriere aufgebracht werden.

Wesentlich ist, dass die Rückseiten-Metallisierung 6 kein Eutektikum mit dem Material des Waferprodukts hat, dessen eutektische Temperatur unterhalb oder nahe bei der Formierungstemperatur des Materials der Metallbasis-Bondingdeckschicht 7 (beispielsweise Silberpaste) liegt. Falls eine Rückseitenmetallisierung 6 aus Aluminium erforderlich ist, kann vorgesehen sein, dass zunächst eine Titan-Barriere aufgebracht wird, um eine Trennung von der Rückseitenmetallisierung 6 zu gewährleisten.

Die beiden korrespondierenden Metallbasis-Bondingdeckschichten 7, 8 werden daraufhin in mechanischen Kontakt gebracht und die dann zwischen dem Waferprodukt 1 und dem Rückseiten-Substrat 10 liegende Metallbasis-Bondingschicht 11 bei höheren Temperaturen formiert. Die Formierungstemperatur liegt dabei beispielsweise im System Silber-Silizium deutlich oberhalb aller nachfolgenden Bearbeitungstemperaturen. Diese liegen in dem genannten System bei höchstens 450 °C, in der Regel aber lediglich bei 380 °C, während die eutektische Temperatur im System Silber-Silizium bei 830 °C liegt. Da in dem vorliegenden Ausführungsbeispiel kein direkter Kontakt zwischen den Oberflächen des Waferprodukts 1 und des Rückseiten-Substrats 10 vorgesehen ist, braucht die Oberfläche des Rückseiten-Substrats 10 auch nicht poliert zu werden. Dadurch ist diese wesentlich einfacher und kostengünstiger herzustellen bzw. zu beschaffen.

Da das Rückseiten-Substrat bzw. ein sogenannter Leitfähigkeitsträger 10 keine pn-Übergänge enthalten muss, sondern elektrisch nur einen möglichst geringen Widerstand aufweisen sollte, kann grundsätzlich auch nicht monokristallines Halbleitermaterial verwendet werden. Jedoch darf keine Metallschicht bzw. ein metallisches Blech verwendet werden, da bei einer nachfolgenden Metallisierung und Passivierung der Vorderseite des Produktwafers 1 Temperaturen von zumindest 250°C und manchmal bis zu 450°C auftreten. Das Rückseiten-Substrat besteht daher vorzugsweise aus einem gleichen Halbleitermaterial wie der Produktwafer 1 und/oder das Vorderseiten-Substrat 3, wodurch sich gleiche Ausdehnungskoeffizienten ergeben.

Vorzugsweise wird als Rückseiten-Substrat 10 ein Trägerwafer verwendet, der aus multikristallinem Halbleitermaterial (z.B. Si) besteht. Zur Herstellung eines derartigen multikristallinem Trägerwafers wird beispielsweise eine sehr stark (z.B. Arsen) dotierte Halbleiterschmelze in zylindrische Behälter gegossen und anschließend ein hinreichend langsamer Abkühlungsprozess durchgeführt. Die Schmelze erstarrt hierbei in sehr grobkörniges d.h. multikristallines Halbleitermaterial wie z.B. Polysilizium, wobei die Korngröße ca. 1mm betragen kann. Abschließend werden die zylindrisch ausgeformten Halbleiterstäbe, die vorzugsweise den gleichen Durchmesser wie die Produktwafer aufweisen, in Scheiben gesägt und beispielsweise überätzt. Ein weitergehendes Polieren ihrer Oberflächen ist hierbei nicht erforderlich. Da die Herstellungskosten für einen derartigen multikristallinen Trägerwafer lediglich ca. 1/10 der Kosten für einen monokristallinen Trägerwafer betragen, können dadurch auch die Herstellungskosten bei der Bearbeitung von ultradünnen bruchgefährdeten Produktwafern wesentlich verringert werden.

Nach dem Entfernen der Schutzschicht 2 werden Metallisierungs-Strukturen 12 und Passivierungs-Strukturen 13 des Waferprodukts 1 aufgebracht. Daraufhin wird eine Rückseiten-Metallisierung 14 hergestellt, mittels der das Schichtpaket aus Rückseiten-Substrat 10 und Produktwafer 1 auf eine Sägefolie 15 montiert und durch Sägen in einzelne Einheiten verarbeitet wird. Die vorgenannten Schritte können unter Beibehaltung des Rückseiten-Substrats 10 durchgeführt werden. Hierzu gehören auch nicht näher beschriebene elektrische Tests, wozu eine leitfähige Verbindung zwischen der Unterseite des Schichtpakets und der Rückseite des Waferprodukts 1 erforderlich ist.

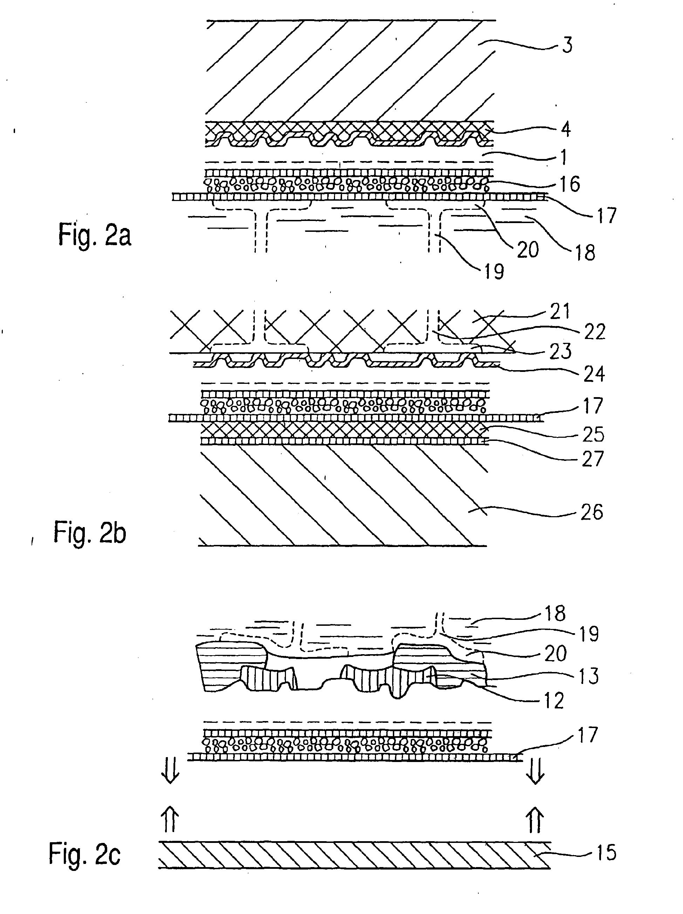

Das Verfahren gemäß Figur 2 geht von der gleichen Ausgangskonfiguration wie Figur 1 aus. Daraufhin wird auf die Rückseite des noch am Vorderseiten-Substrat 3 (Hochtemperaturträger) montierten Waferprodukts 1 mittels der Silberpaste 16 eine dünne Kupferfolie 17 bei der Formierungstemperatur der Silberpaste 16 montiert. Daraufhin wird das Schichtpaket säuredicht mit einem Nassätzchuck, der aus einem Fluorelastomer 18 besteht, in das an eine Vakuumpumpe angeschlossene Bohrungen 19 und ein Kanalsystem 20 eingebracht sind, angesaugt. Daraufhin wird das Vorderseiten-Substrat 3 entfernt. Sodann kann die Flüssigglas-Bondingschicht 4 (oder ein entsprechender Faserbond) mittels Flußsäure abgelöst werden, wobei das (ultradünne) Waferprodukt in seiner Form gehalten wird.

Da die Metalle der vorgesehenen Verbindung (z.B. Silber und Gold) Edelmetalle sind, ist der Angriff der Flußsäure beziehungsweise einer Lösung gepufferter Flußsäure auf das jeweilige Metal relativ gering.

Daraufhin wird das Waferprodukt 1 an einen Hot-Chuck 21 mit Bohrungen 22 und Kanalsystemen 23 übergeben. Der Hot-Chuck 21, der an der Schutzschicht 24 direkt angreift, verbindet das gesamte Schichtpaket mittels eines Flüssigglas-Faserbondes 25 mit einem leitfähigen Trägerwafer 26 (dieser bildet in dem gezeigten Ausführungsbeispiel das Rückseiten-Substrat). Hierbei ist der leitfähige Trägerwafer 26 mit einer metallischen Kontaktschicht 25 ausgestattet. Um die elektrische Leitfähigkeit des Schichtpaketes zu gewährleisten, können als Fasern beispielsweise Kohlefasern verwendet werden.

Nach der Formierung der Metallisierungsstrukturen 12 und der Passivierungsstrukturen 13 wird der Trägerwafer 26 wieder mittels eines Nassätzchucks getrennt. Daraufhin wird das verbleibende, ultradünne Waferprodukt mitsamt der Kupferfolie 17 als unterste Lage auf die Sägefolie 15 montiert und wie oben beschriebenen vereinzelt.

Für den Fall, dass die Kupferfolie 17 hinreichend dick ist, kann die Verbindung mit dem Trägerwafer 26 auch durch ein niedrigschmelzendes, wieder lösbares Lötzinn hergestellt werden. Beispielsweise liegt das Eutektikum eines Gemisches von 68% Blei ,20 Prozent Zinn und zwei Prozent Silber bei 179 Grad Celsius. Da die niedrigste eutektische Temperatur mit Kupfer bei 232 Grad Celsius liegt, kann man das Lötzinn wieder von der Kupferfolie 17 lösen, ohne diese aufzuschmelzen.

In Figur 3 ist gezeigt, wie die Silberpartikel 29 der Silberpaste, dargestellt durch die gestrichelten Kreise, durch Oberflächenmigration zu einem zusammenhängenden Bereich verwachsen. Dadurch wird die mechanische Stabilität sowie die elektrische Leitfähigkeit erzielt. Da die Silberpaste mittels eines Siebdruckverfahrens aufgebracht wird, stellen großräumige Oberflächenwelligkeiten 28 der gedünnten Rückseite des Waferprodukts 1 keinen Hinderungsgrund für die Anwendung des vorstehend beschriebenen Verfahrens dar.

Schließlich zeigt Figur 4 eine strukturierte Aufbringung der Silberpaste 30, wobei Unterbrechungszonen vorgesehen sind, in denen keine Silberpaste 30 aufgebracht ist. Dadurch kann die Kupferfolie 31 der Differenzverschiebung der thermischen Wärmeausdehnungen durch lokale Verformung ausweichen. Somit werden unzulässig hohe, thermische Spannungen im Silizium 1 des Produktwafers vermieden.

## Patentansprüche

1. Verfahren zur mehrschrittigen Bearbeitung eines dünnen und unter den Bearbeitungsschritten bruchgefährdeten Halbleiter-Waferprodukts (1), wobei
an der aktiven Vorderseite des Waferprodukts (1) mittels einer Bondingschicht (4) ein Vorderseiten-Substrat (3) montiert ist,
die Rückseite des Waferprodukts (1) einer Hochtemperaturbehandlung unterworfen wird,
daraufhin auf die Rückseite und/oder auf ein Rückseiten-Substrat (10) aus elektrisch leitfähigem Material ein Metallbasis-Bondingmaterial als Metallbasis-Bondingdeckschicht (7) aufgetragen wird,
anschließend die Rückseite des Waferprodukts (1) und das Rückseiten-Substrat (10) mit dem dazwischen liegenden Metallbasis-Bondingmaterial in gegenseitigen Kontakt gebracht und eine leitfähige Metallbasis-Bondingschicht (11) durch Wärmebehandlung formiert wird, und
schließlich das Vorderseiten-Substrat (3) von der Vorderseite entfernt und die Vorderseite strukturiert metallisiert/passiviert wird, wobei
das Metallbasis-Bondingmaterial hinsichtlich seiner physikalisch-chemischen Eigenschaften unter Berücksichtigung des Waferprodukt-Materials und der bei der Metallisierung/Passivierung herrschenden Temperaturen und verwendeten Materialien derart ausgewählt ist, dass
die in benachbarten Schichten angeordneten Materialien des Waferprodukts (1) und der Metallbasis-Bondingschicht (11) kein Eutektikum bilden.

2. Verfahren nach Anspruch 1, **dadurch gekennzeichnet, dass** als Metallbasis-Bondingmaterial Silberpaste, insbesondere Dickschicht-Silberpaste oder eine Leitpaste aus Silberlegierungen, anderen Edelmetallen oder Edelmetalllegierungen, verwendet wird.

3. Verfahren nach Anspruch 1 oder 2, **dadurch gekennzeichnet, dass** die Rückseite des Waferprodukts (1) und/oder die Kontaktfläche des Rückseiten-Substrats (10) vor dem Auftrag der Metallbasis-Bondingdeckschicht (7,8) metallisiert wird.

4. Verfahren nach Anspruch 2 und 3, **dadurch gekennzeichnet, dass** Kupfer als Metallisierung zwischen der Silberpaste und dem Waferprodukt (1) bzw. zwischen der Silberpaste und der Kontaktfläche des Rückseiten-Substrats (10) verwendet wird.

5. Verfahren nach Anspruch 2 und 3, **dadurch gekennzeichnet, dass** zwischen der Silberpaste und dem Waferprodukt (1) eine Schichtfolge aus Aluminium, Titan und Silber aufgebracht wird.

6. Verfahren nach einem der Ansprüche 1 bis 5, **dadurch gekennzeichnet, dass** die Formierungstemperatur zwischen 500 und 700 Grad Celsius beträgt.

7. Verfahren nach einem der Ansprüche 1 bis 5, **dadurch gekennzeichnet, dass** eine Al-Metallisierung vorgesehen ist, und dass die Formierungstemperatur der Metallbasis-Bondingschicht (11) kleiner oder gleich 500 Grad Celsius ist.

8. Verfahren nach Anspruch 1, **dadurch gekennzeichnet, dass** als Metallbasis-Bondingmaterial Gold verwendet wird, wobei zwischen dem Goldmaterial und dem Waferprodukt-Material Barriereschichten vorgesehen werden.

9. Verfahren nach Anspruch 8, **dadurch gekennzeichnet, dass** die Verbindung mittels Gold-Druck-Bonding realisiert wird.

10. Verfahren nach einem der Ansprüche 1 bis 9, **dadurch gekennzeichnet, dass** auf die Rückseite des Waferprodukts (1) vor der Montage des Rückseiten-Substrats (10) eine dünne Kupferfolie (17) aufgebondet wird.

11. Verfahren nach Anspruch 10, **dadurch gekennzeichnet, dass** die Verbindung zwischen der dünnen Kupferfolie (17) und dem Rückseiten-Substrat (10) mittels eines Flüssigglas-Faserbondes mit Kohlefasern hergestellt wird.

12. Verfahren nach einem der Ansprüche 1 bis 11, **dadurch gekennzeichnet, dass** das Waferprodukt (1) monokristallines Silizium mit einer Schichtdicke von weniger als 100 Mikrometern ist.

13. Verfahren nach einem der Ansprüche 1 bis 12, **dadurch gekennzeichnet, dass** das Vorderseiten-Substrat (3) mittels eines Flüssigglas-Faserbondes (4) aufgebracht ist und zum Entfernen des Vorderseiten-Substrats eine Flußsäurelösung verwendet ,wird.

14. Verfahren nach einem der Ansprüche 1 bis 13, **dadurch gekennzeichnet, dass** das Rückseiten-Substrat (10) aus höchstdotiertem, monokristallinem Silizium besteht.

15. Verfahren nach einem der Ansprüche 1 bis 14, **dadurch gekennzeichnet, dass** das Metallbasis-Bondingmaterial strukturiert aufgebracht wird.

16. Verfahren nach einem der Ansprüche 1 bis 15, **dadurch gekennzeichnet, dass** auf der Rückseite des Waferprodukts (1) vor dessen leitfähiger Verbindung mit dem Rückseiten-Substrat (10) Hochtemperatur-Diffusionen durchgeführt werden.

17. Verfahren nach einem der Ansprüche 1 bis 16, **dadurch gekennzeichnet, dass** auf der Rückseite des Waferprodukts (1) vor dessen leitfähiger Verbindung mit dem Rückseiten-Substrat (10) metallische Verdrahtungsstrukturen ausgebildet werden.

18. Verfahren nach einem der Ansprüche 1 bis 17, **dadurch gekennzeichnet, dass** das Material des Rückseiten-Substrats (10) einen thermischen Ausdehnungskoeffizienten aufweist, der dem des Waferprodukt-Materials entspricht.

19. Verfahren nach einem der Ansprüche 1 bis 13 und 15 bis 18, **dadurch gekennzeichnet, dass** das Rückseiten-Substrat (10) ein nicht monokristallines Halbleitermaterial aufweist.

20. Verfahren nach einem der Ansprüche 1 bis 13 und 15 bis 19, **dadurch gekennzeichnet, dass** das Rückseiten-Substrat (10) ein multikristallines Halbleitermaterial aufweist.

21. Verfahren nach einem der Ansprüche 1 bis 13 und 15 bis 20, **dadurch gekennzeichnet, dass** das Rückseiten-Substrat (10) einen unpolierten Trägerwafer darstellt.

## Claims

1. Process for the multistep processing of a thin semiconductor wafer product (1) that is liable to break in the processing steps, wherein
a front-side substrate (3) is mounted on the active front side of the wafer product (1) by means of a bonding layer (4),
the rear side of the wafer product (1) is subjected to a high-temperature treatment,
then a metal-based bonding material is applied as a metal-based bonding overlayer (7) to the rear side and/or to a rear-side substrate (10) of electrically conductive material,
subsequently, the rear side of the wafer product (1) and the rear-side substrate (10) with the metal-based bonding material lying in between are brought into mutual contact and a conductive metal-based bonding layer (11) is formed by heat treatment, and
finally, the front-side substrate (3) is removed from the front side and the front side is metallized/passivated in a structured form, wherein the metal-based bonding material is selected with regard to its physical-chemical properties, and with consideration given to the wafer product material and the temperatures prevailing and materials used in the metallization/passivation, in such a way that
the materials of the wafer product (1) and of the metal-based bonding layer (11) arranged in neighbouring layers do not form a eutectic mixture.

2. Process according to Claim 1, **characterized in that** silver paste, in particular thick-film silver paste or a conductive paste of silver alloys, other noble metals or noble metal alloys, is used as the metal-based bonding material.

3. Process according to Claim 1 or 2, **characterized in that** the rear side of the wafer product (1) and/or the contact area of the rear-side substrate (10) is metallized before the application of the metal-based bonding overlayer (7, 8).

4. Process according to Claims 2 and 3, **characterized in that** copper is used as the metallization between the silver paste and the wafer product (1) or between the silver paste and the contact area of the rear-side substrate (10).

5. Process according to Claims 2 and 3, **characterized in that** a sequence of layers comprising aluminium, titanium and silver is applied between the silver paste and the wafer product (1).

6. Process according to one of Claims 1 to 5, **characterized in that** the forming temperature is between 500 and 700 degrees Celsius.

7. Process according to one of Claims 1 to 5, **characterized in that** an Al metallization is provided, and **in that** the forming temperature of the metal-based bonding layer (11) is less than or equal to 500 degrees Celsius.

8. Process according to Claim 1, **characterized in that** gold is used as the metal-based bonding material, barrier layers being provided between the gold material and the wafer product material.

9. Process according to Claim 8, **characterized in that** the connection is realized by means of gold pressure bonding.

10. Process according to one of Claims 1 to 9, **characterized in that**, before the mounting of the rear-side substrate (10), a thin copper foil (17) is bonded onto the rear side of the wafer product (1).

11. Process according to Claim 10, **characterized in that** the connection between the thin copper foil (17) and the rear-side substrate (10) is established by means of a liquid glass fibre bond with carbon fibres.

12. Process according to one of Claims 1 to 11, **characterized in that** the wafer product (1) is monocrystalline silicon with a layer thickness of less than 100 micrometres.

13. Process according to one of Claims 1 to 12, **characterized in that** the front-side substrate (3) is applied by means of a liquid glass fibre bond (4) and a hydrofluoric acid solution is used for removing the front-side substrate.

14. Process according to one of Claims 1 to 13, **characterized in that** the rear-side substrate (10) consists of extremely highly doped, monocrystalline silicon.

15. Process according to one of Claims 1 to 14, **characterized in that** the metal-based bonding material is applied in a structured form.

16. Process according to one of Claims 1 to 15, **characterized in that**, before its conductive connection to the rear-side substrate (10), high-temperature diffusions are carried out on the rear side of the wafer product (1).

17. Process according to one of Claims 1 to 16, **characterized in that**, before its conductive connection to the rear-side substrate (10), metallic wiring structures are formed on the rear side of the wafer product (1).

18. Process according to one of Claims 1 to 17, **characterized in that** the material of the rear-side substrate (10) has a coefficient of thermal expansion which corresponds to that of the wafer product material.

19. Process according to one of Claims 1 to 13 and 15 to 18, **characterized in that** the rear-side substrate (10) comprises a non-monocrystalline semiconductor material.

20. Process according to one of Claims 1 to 13 and 15 to 19, **characterized in that** the rear-side substrate (10) comprises a multicrystalline semiconductor material.

21. Process according to one of Claims 1 to 13 and 15 to 20, **characterized in that** the rear-side substrate (10) represents an unpolished carrier wafer.

## Revendications

1. Procédé de traitement en plusieurs stades d'une plaquette (1) semiconductrice mince et menaçant de se rompre sous l'effet des stades de traitement, dans lequel :
on monte sur la face avant active de la plaquette (1) un substrat (3) de face avant au moyen d'une couche (4) de liaison,
on soumet la face arrière de la plaquette (1) à un traitement à haute température,
ensuite, on dépose sur la face arrière et/ou sur un substrat (10) de face arrière, en un matériau conducteur de l'électricité, un matériau de liaison à base de métal en tant que couche (7) de finition de liaison à base de métal,
ensuite, on met la face arrière de la plaquette (1) et le substrat (10) de face arrière en contact mutuel avec le matériau de liaison à base de métal qui se trouve entre eux et on forme par traitement thermique une couche (11) de liaison à base de métal conductrice de l'électricité, et
enfin, on retire le substrat (3) de face avant de la face avant et on métallise en la structurant/passive la face avant,
dans lequel on choisit les propriétés physico-chimiques du matériau de liaison à base de métal en tenant compte du matériau de la plaquette et des températures régnant et des matériaux utilisés lors de la métallisation/passivation de façon à ce que
les matériaux de la plaquette (1) et la couche (11) de liaison à base de métal disposée dans des couches voisines ne forment pas de d'eutectique.

2. Procédé suivant la revendication 1, **caractérisé en ce que** l'on utilise comme matériau de liaison à base de métal, de la pâte d'argent, notamment de la pâte d'argent en couche épaisse, ou une pâte conductrice en des alliages d'argent, en d'autres métaux précieux ou en des alliages de métaux précieux.

3. Procédé suivant la revendication 1 ou 2, **caractérisé en ce que** l'on métallise la face arrière de la plaquette (1) et/ou la surface de contact du substrat (10) de face arrière avant le dépôt de la couche (7, 8) de finition de liaison à base de métal.

4. Procédé suivant la revendication 2 ou 3, **caractérisé en ce que** l'on utilise du cuivre comme métallisation entre la pâte d'argent et la plaquette (1) ou entre la pâte d'argent et la surface de contact du substrat (10) de face arrière.

5. Procédé suivant les revendications 2 et 3, **caractérisé en ce que** l'on dépose une succession de couches en aluminium, titane et argent entre la pâte d'argent et la plaquette (1).

6. Procédé suivant l'une des revendications 1 à 5, **caractérisé en ce que** la température de formage est comprise entre 500 et 700°C.

7. Procédé suivant l'une des revendications 1 à 5, **caractérisé en ce qu'**il est prévu une métallisation à l'Al et **en ce que** la température de formage de la couche (11) de liaison à base de métal est inférieure ou égale à 500°C.

8. Procédé suivant la revendication 1, **caractérisé en ce que** l'on utilise de l'or comme matériau de liaison à base de métal, des couches formant barrière étant prévues entre le matériau en or et le matériau de plaquette.

9. Procédé suivant la revendication 8, **caractérisé en ce que** l'on réalise la liaison au moyen d'une liaison or-pression.

10. Procédé suivant l'une des revendications 1 à 9, **caractérisé en ce que** l'on applique par liaison une mince feuille (17) de cuivre sur la face arrière de la plaquette (1) avant le montage du substrat (10) de face arrière.

11. Procédé suivant la revendication 10, **caractérisé en ce que** l'on ménage la liaison entre la mince feuille (17) de cuivre et le substrat (10) de face arrière au moyen d'une liaison verre liquide-fibres ayant des fibres de carbone.

12. Procédé suivant l'une des revendications 1 à 11, **caractérisé en ce que** la plaquette (1) est du silicium monocristallin ayant une épaisseur de couche de moins de 100 microns.

13. Procédé suivant l'une des revendications 1 à 12, **caractérisé en ce que** l'on dépose le substrat (3) de face avant au moyen d'une liaison (4) verre liquide-fibres ou et on utilise une solution d'acide fluorhydrique pour éliminer le substrat de face avant.

14. Procédé suivant l'une des revendications 1 à 13, **caractérisé en ce que** le substrat (10) de face arrière est en silicium monocristallin très dopé.

15. Procédé suivant l'une des revendications 1 à 14, **caractérisé en ce que** l'on dépose de façon structurée le matériau de liaison à base de métal.

16. Procédé suivant l'une des revendications 1 à 15, **caractérisé en ce que** l'on effectue des diffusions à haute température sur la face arrière de la plaquette (1) avant sa liaison conductrice avec le substrat (10) de face arrière.

17. Procédé suivant l'une des revendications 1 à 16, **caractérisé en ce que** l'on forme des structures de câblage métalliques sur la face arrière de la plaquette (1) avant sa liaison conductrice avec le substrat (10) de face arrière.

18. Procédé suivant l'une des revendications 1 à 17, **caractérisé en ce que** le matériau du substrat (10) de face arrière a un coefficient de dilation thermique qui correspond à celui du matériau de la plaquette.

19. Procédé suivant l'une des revendications 1 à 13 et 15 à 18, **caractérisé en ce que** le substrat (10) de face arrière comprend un matériau semiconducteur qui n'est pas monocristallin.

20. Procédé suivant l'une des revendications 1 à 13 et 15 à 19, **caractérisé en ce que** le substrat (10) de face arrière comprend un matériau semiconducteur multicristallin.

21. Procédé suivant l'une des revendications 1 à 13 et 15 à 20, **caractérisé en ce que** le substrat (10) de face arrière constitue une plaquette support non polie.
